# DEMANDE DE BREVET EUROPEEN

(11) **EP 1 018 652 A1**
(43) Date de publication de la demande: **12.07.2000**
(21) Numéro de dépôt: 99403119.3
(22) Date de dépôt: 13.12.1999
(51) Int. Cl.: G01R 31/36

(54) **Circuit de mesure pour ensemble de cellules électriques montées en série**

(30) Priorité: 07.01.1999 FR 9900089
(71) Demandeur: ALCATEL, 75008 Paris (FR)
(72) Inventeur: Carton, Jean-Luc, 91440 Bures sur Yvette (FR); Morin, Christophe, 33290 Blanchefort (FR); Perelle, Michel, 37210 Parcay-Meslay (FR); Equoy, Régis, 33160 St Medard en Jalles (FR)
(74) Mandataire: Lamoureux, Bernard

(57) **Abrégé**

Circuit de mesure pour ensemble de cellules (2) électriques en série auxquelles sont associées des interfaces individuelles (4) de mesure et un traducteur de mesure (5) auquel les interfaces fournissent successivement leurs signaux de mesure par l'intermédiaire d'une première liaison série (M), en réponse à des impulsions de sélection d'interface transmises en série d'une interface à l'autre par une liaison (L), depuis une logique commune (6). Chaque signal de mesure est transmis au traducteur, soit directement pour la plus proche du traducteur, soit via une ou plusieurs interfaces, non sélectionnées, qu'il traverse, suivant la position de l'interface, qui le produit, dans la suite des interfaces. Un aiguilleur (9), un générateur de signal de mesure (10) et un translateur (11) sont associés à cet effet dans chaque interface.

Des diodes de protection (12, 12') sont montés en série dans les éléments de liaison situés entre des interfaces de deux cellules successives.

## Description

L'invention concerne un circuit de mesure pour ensemble modulaire de cellules électriquement montées en série et plus particulièrement pour ensemble à cellules constituées chacune d'un ou de plusieurs éléments producteurs, accumulateurs ou convertisseurs d'énergie électrique. Elle concerne plus particulièrement les ensembles à cellules multiples fonctionnant à tension élevée.

Comme il est connu, l'exploitation des ensembles composés de cellules électriques montées en série, est susceptible d'être largement optimisée, notamment lorsque le nombre de cellules est relativement grand, s'il est possible de contrôler avec précision le fonctionnement de chaque cellule et par conséquent d'effectuer des mesures cellule par cellule.

Le document EP-A-0678 753, décrit un circuit de mesure prévu pour de tels ensembles de cellules. Il permet de réaliser des mesures précises tout en réduisant le nombre de liaisons électriques nécessaires à la transmission des signaux de mesure. Une première liaison, de type série, dessert des interfaces de mesure individuellement affectées aux cellules et permet de faire prendre en compte successivement par un transducteur commun les signaux de mesure obtenus par l'intermédiaire de générateurs de courant situés au niveau des interfaces. Une seconde liaison, de type série, permet de transmettre des impulsions de sélection individuelle aux interfaces depuis une logique commune.

Or il existe un certain nombre de cas où il est intéressant de disposer d'une tension élevée aux bornes d'un ensemble de cellules, par exemple pour commander le moteur dans le cas d'un véhicule électrique. Ceci n'est pas sans conséquence au niveau des interfaces du circuit de mesure d'un tel ensemble de cellules, dans la mesure où des composants d'interface peuvent être amenés à supporter une tension élevée allant jusqu'à correspondre à celle présente aux bornes de l'ensemble et où des dysfonctionnements susceptibles d'intervenir en phase d'exploitation de l'ensemble de cellules peuvent amener à l'apparition de tensions anormales et notamment inversées aux bornes d'entrée/sortie des interfaces.

L'invention propose donc un circuit de mesure pour ensemble modulaire de cellules électriquement montées en série, constituées chacune d'un ou de plusieurs éléments producteurs, accumulateurs ou convertisseurs d'énergie électrique, et auxquelles sont associées des interfaces individuelles de mesure par cellule et un traducteur de signal de mesure, commun, auquel les interfaces fournissent successivement des signaux de mesure par l'intermédiaire d'une première liaison, en réponse à des impulsions de sélection individuelle d'interface transmises depuis une logique commune par une seconde liaison.

Selon une caractéristique de l'invention, les interfaces successives sont reliées entre elles par des éléments de la première et de la seconde des liaisons qui sont de type série, au moins deux interfaces correspondant à deux cellules successives étant reliées par deux éléments, l'un de première liaison et l'autre de seconde liaison, comportant chacun une diode de protection montée en série pour agir en cas de tension inverse et notamment en cas de rupture de continuité électrique entre les cellules auxquelles correspondent les interfaces entre lesquelles ces diodes sont montées.

L'invention propose aussi un circuit de mesure pour ensemble modulaire de cellules électriquement montées en série, constituées chacune d'un ou de plusieurs éléments producteurs, accumulateurs ou convertisseurs d'énergie électrique, et auxquelles sont associées des interfaces individuelles de mesure par cellule et un traducteur de signal de mesure, de type transducteur, auquel les interfaces transmettent successivement, au travers d'une première liaison, les signaux de mesure qu'elles produisent respectivement en réponse à des impulsions de sélection individuelle d'interface transmises depuis une logique commune, chaque interface comportant un circuit de traitement d'impulsions de sélection par l'intermédiaire duquel elle est sélectionnée.

Selon une caractéristique de l'invention, dans ce circuit où les interfaces successives sont reliées entre elles par des éléments de la première liaison, de type série, chaque interface comporte un dispositif qui associe un aiguilleur commandé par le circuit de traitement d'impulsions de **sélection**, à un générateur de signal analogique de mesure et à un translateur. L'aiguilleur assure alternativement la mise en communication, via la première liaison, du générateur de signal analogique de mesure au traducteur de signal de mesure, lorsque l'interface est sélectionnée, et celle du translateur à ce traducteur de signal de mesure, lorsque l'interface n'est pas sélectionnée, le translateur permettant alors une transmission intégrale d'un signal analogique de mesure, au travers de l'interface à destination du traducteur, lorsque ce signal est reçu d'une autre interface située en amont sur la première liaison vis-à-vis du traducteur.

Selon une caractéristique de l'invention, une seconde liaison de type série transmet les impulsions de sélection individuelle d'interface émises par la logique i commune, où la première et la seconde liaison sont respectivement constituées d'éléments qui sont insérés chacun entre deux interfaces correspondant à deux cellules successives et où au moins deux interfaces correspondant à deux cellules successives sont reliées par deux éléments, l'un de première liaison et l'autre de seconde liaison, comportant chacun une diode de protection montée en série pour agir en cas de tension inverse et notamment en cas de rupture de continuité électrique entre les cellules auxquelles correspondent les interfaces entre lesquelles ces diodes sont montées.

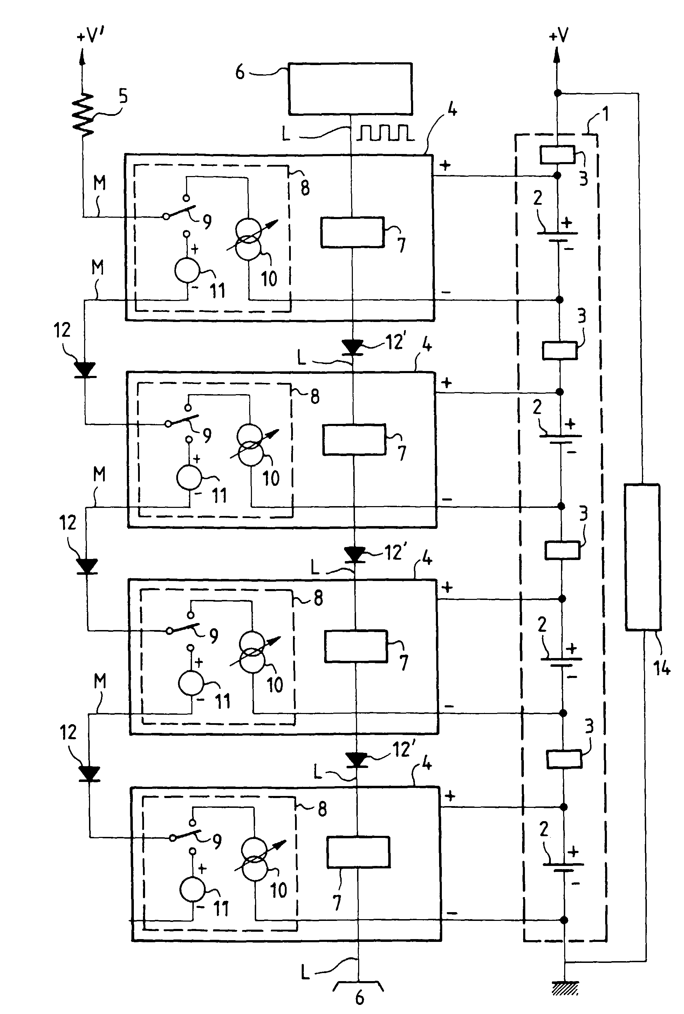

L'invention, ses caractéristiques et ses avantages sont précisés dans la description qui suit en liaison avec la figure unique évoquée ci-dessous.

Cette figure unique présente un schéma électrique de principe d'un ensemble modulaire de cellules électriques, de type accumulateur, auquel est associé un circuit de mesure selon l'invention.

Le circuit de mesure illustré sur la figure unique est destiné à être associé à un ensemble électrique modulaire 1 composé d'une pluralité de cellules 2 connectées en série au niveau des bornes de transmission d'énergie qu'elles comportent, une cellule disposant classiquement de deux bornes référencées "+" et "-". Chaque cellule est composée de plusieurs éléments qui sont par exemple producteurs, convertisseurs ou accumulateurs d'énergie électrique parmi ces derniers, outre les accumulateurs proprement dits, figurent aussi les piles et les supercondensateurs. L'ensemble 1 , illustré, est supposé constitué de cellules électriques 2, de type accumulateur. C'est par exemple un ensemble d'alimentation en énergie, pour moteur de véhicule électrique, qui est constitué de cellules de douze volts montées en série de manière à fournir une tension continue d'exploitation de plusieurs centaines de volts. Pour des raisons de sécurité et dans la mesure où des courants importants sont susceptibles d'être produits dans un ensemble tel qu'envisagé ci-dessus, il est prévu au moins un dispositif 3, tel qu'un fusible de protection et/ou un organe de coupure, entre au moins deux des cellules de l'ensemble, par exemple entre les deux cellules situées au milieu de la suite formée par les cellules en série.

Le circuit de mesure selon l'invention est destiné à permettre de collecter des informations relatives au fonctionnement des cellules 2 d'un ensemble 1 et par exemple de déterminer la valeur de la tension continue présente aux bornes de chacune des cellules. Il comporte des interfaces de mesure individuelles 4 pour chacune des cellules de l'ensemble auquel il est associé. Les signaux de mesure obtenus au niveau de ces interfaces 4 sont successivement transmis vers un traducteur de signal de mesure 5, commun, analogique ou numérique, par l'intermédiaire d'une liaison M, de type série, entre des éléments successifs de laquelle les interfaces sont respectivement insérées. La transmission de ces signaux est régie par une logique 6 qui émet des impulsions de sélection individuelle d'interface par trains, ici sur une liaison L de type série, elle aussi composée d'éléments successifs entre lesquels les interfaces sont respectivement insérées.

Dans l'exemple de réalisation envisagé ici, les impulsions de sélection sont supposées successivement transmises d'une interface à l'autre à partir de la logique 6 via les éléments formant la liaison L. Chaque interface comporte un circuit de traitement d'impulsions de sélection 7 qui prend, par exemple, en compte l'une des impulsions de sélection d'un train qui est la première impulsion, en provenance de la logique 6, qu'il reçoit pour ce train. La ou les autres impulsions de sélection qui sont reçues par le circuit de traitement 7 d'une interface dans le cadre d'un train d'impulsions, est ou sont transmises par ce circuit, via la liaison L, vers le circuit de traitement de l'interface suivante.

Les circuits de traitement 7 des interfaces ne sont pas décrits plus avant dans la mesure où ils sont connus de l'homme de métier, un exemple figurant notamment dans le document EP-A-0678 753 évoqué plus haut.

Le circuit de traitement d'impulsions de sélection 7 d'une interface 4 est prévu pour commander la fourniture du signal de mesure produit par l'interface au traducteur de signal de mesure 5, lorsqu'il a reçu une impulsion de sélection individuelle à cet effet. Ce signal est supposé analogique dans la suite de la description. Il peut éventuellement être un signal numérique fourni au traducteur de mesure, alors lui aussi de type numérique, à partir d'une mesure effectuée au niveau d'une cellule par l'intermédiaire de l'interface affectée à cette cellule. La logique 6 est reliée au traducteur de signal de mesure de manière éventuellement classique, non représentée, pour prendre en compte les signaux de mesure obtenus., cette logique étant par exemple une logique programmée constituée d'une manière classique autour d'un processeur auquel sont notamment associées des mémoires et une horloge.

Dans la réalisation présentée, le circuit de traitement d'impulsions de sélection 7 vient agir sur un aiguilleur 9 d'un dispositif 8 où cet aiguilleur est associé à un générateur de signal de mesure 10 et à un translateur 11 qui est par exemple réalisé en technologie MOS comme l'aiguilleur 9.

L'aiguilleur 9 d'une interface de cellule est par exemple constitué de deux transistors MOS. Ces transistors sont commandés pour assurer une mise en communication alternative, via la liaison M, du générateur de signal de mesure 10 au traducteur de signal de mesure 5 du circuit, lorsque l'interface de la cellule considérée est sélectionnée, et celle du translateur 11 à ce traducteur de signal de mesure, lorsque cette interface n'est pas sélectionnée.

Le translateur 11 permet une transmission intégrale d'un signal de mesure, au travers de l'interface à destination du traducteur de signal de mesure 5, lorsque l'interface n'est pas sélectionnée et que le signal reçu parvient d'une autre interface située en amont sur la première liaison, vis-à-vis du traducteur. L'aiguilleur 9 de l'interface relie alors les deux éléments de liaison M entre lesquelles cette interface est insérée.

Dans l'exemple de réalisation présenté ici, chaque dispositif 8 comporte un générateur de signal de mesure 10 qui est de type générateur de courant, de type analogique. Ce générateur permet de modifier l'intensité du courant circulant dans le traducteur de signal de mesure 5, via la liaison M. L'intensité de ce courant est modifiée par le générateur de signal de mesure 10 d'une interface 4 alors sélectionnée, en fonction d'une mesure effectuée au niveau de cette interface et par exemple en fonction de la tension présente aux bornes de la cellule à laquelle l'interface sélectionnée est affectée.

Dans l'exemple présenté, l'intensité du courant qui est produite par un générateur de signal de mesure 10 d'une interface en fonction d'une mesure effectuée, est appliquée à la résistance constituant le traducteur de signal de mesure 5, lorsque l'interface est sélectionnée par l'intermédiaire d'une impulsion et que l'élément 8 de cette interface aiguille le signal de mesure que constitue le courant vers la résistance formant le traducteur 5. Ce signal de mesure transite alors par l'intermédiaire des éléments de liaison M, ainsi que des éléments aiguilleurs 9 et des translateurs 11 des interfaces qui sont situées entre l'interface alors sélectionnée et le traducteur de mesure 5.

Les translateurs 11 de ces interfaces non sélectionnées sont alors mis en ligne par les aiguilleurs qui leur sont respectivement associés dans ces interfaces. Ils permettent une transmission intégrale du signal analogique de mesure qui traverse les interfaces où ils sont incorporés. Dans la réalisation envisagée, la résistance formant le traducteur de mesure 5 est reliée à un potentiel V' légèrement supérieur au potentiel positif V de l'ensemble 1, pour le cas où le signal analogique de mesure est fourni par l'interface située immédiatement en amont.

Selon l'invention, il est prévu d'insérer une diode de protection 12 sur au moins un des éléments de la liaison M pour éviter l'application d'une tension inverse élevée au niveau des interfaces, via cette liaison, en cas de rupture de continuité électrique entre cellules 2 de l'ensemble 1. En effet, lorsque l'ensemble 1 est en exploitation il est associé à une charge 14 qui présente une résistance interne faible dans certaines applications et en particulier si la charge est un moteur électrique. De ce fait, la tension, apparaissant en cas de rupture volontaire ou accidentelle de continuité entre cellules 2, est inverse et peut être trop grande pour pouvoir être supportée par les interfaces, en l'absence de diode de protection. Une telle tension inverse peut éventuellement correspondre à la tension nominale de l'ensemble 1, soit donc éventuellement plusieurs centaines de volts.

Pour une raison analogue, une diode de protection 12' est également placée sur l'élément de liaison L reliant les mêmes interfaces qu'un élément de liaison M comportant une diode de protection 12.

Dans l'exemple illustré sur la figure unique, il est prévu des diodes de protection 12 et 12' sur tous les éléments de liaison L et M reliant deux interfaces entre elles, bien entendu ces diodes peuvent alternativement être montées dans l'une ou l'autre des interfaces auxquelles elles sont associées. En variante, il est possible de prévoir des diodes de protection 12 et 12' pour un groupe d'interfaces avec donc un minimum d'une diode par liaison L, M, si la tension inverse susceptible d'apparaître le permet. Un tel cas limite est notamment envisageable lorsqu'il est prévu que les cellules 2 en série d'un ensemble 1 soient réparties dans deux sous-ensembles correspondant par exemple chacun à un bac d'accumulateurs et qu'un dispositif 3 incluant un fusible et/ou éventuellement un organe de coupure, est positionné entre les deux sous-ensembles. Les diodes 12 et 12' sont alors insérées entre les deux interfaces 4 qui sont affectées aux cellules 2 appartenant chacune à un sous-ensemble différent entre lesquelles le dispositif 11 est positionné. Bien entendu, d'autres variantes sont envisageables.

Les interfaces 4 envisagées ici sont du genre de celles figurant dans les descriptions contenues dans les documents EP-A-0657745 et EP-A-0678753. Le générateur de mesure 10 que chacune de ces interfaces comporte est par exemple organisé autour d'un montage permettant de mesurer la tension présente aux bornes de la cellule à laquelle l'interface est affectée.

## Revendications

1. Circuit de mesure pour ensemble modulaire de cellules (2) électriquement montées en série, constituées chacune d'un ou de plusieurs éléments producteurs, accumulateurs ou convertisseurs d'énergie électrique, et auxquelles sont associées des interfaces individuelles (4) de mesure par cellule et un traducteur de signal de mesure (5), auquel les interfaces fournissent successivement leurs signaux de mesure par l'intermédiaire d'une première liaison (M), en réponse à des impulsions de sélection individuelle d'interface transmises depuis une logique commune (6) par une seconde liaison (L), caractérisé en ce que les interfaces successives sont reliées entre elles par des éléments de la première et de la seconde des liaisons qui sont de type série, au moins deux interfaces correspondant à deux cellules successives étant reliées par deux éléments, l'un de première liaison et l'autre de seconde liaison, comportant chacun une diode de protection (12, 12') montée en série pour agir en cas de tension inverse et notamment en cas de rupture de continuité électrique entre les cellules auxquelles correspondent les interfaces entre lesquelles ces diodes sont montées.

2. Circuit de mesure pour ensemble modulaire de cellules (1) électriquement montées en série, constituées chacune d'un ou de plusieurs éléments producteurs, accumulateurs ou convertisseurs d'énergie électrique, et auxquelles sont associées des interfaces individuelles (4) de mesure par cellule et un traducteur de signal de mesure (5), de type transducteur, auquel les interfaces transmettent successivement, au travers d'une première liaison (M), les signaux de mesure en courant qu'elles produisent respectivement en réponse à des impulsions de sélection individuelle d'interface transmises depuis une logique commune (6), chaque interface comportant un circuit de traitement d'impulsions de sélection (7) par l'intermédiaire duquel elle est sélectionnée, caractérisé en ce que dans ce circuit où les interfaces successives sont reliées entre elles par des éléments de la première liaison qui est de type série, chaque interface comporte un dispositif (8) qui associe un aiguilleur (9) commandé par le circuit de traitement d'impulsions de sélection (7), à un générateur de signal analogique de mesure (10) et à un translateur (11), l'aiguilleur assurant alternativement la mise en communication, via la première liaison, du générateur de signal analogique de mesure au traducteur de signal de mesure, commun, lorsque l'interface est sélectionnée, et celle du translateur à ce traducteur de signal de mesure, lorsque l'interface n'est pas sélectionnée, le translateur permettant alors une transmission intégrale d'un signal analogique de mesure, au travers de l'interface à destination du traducteur, lorsque ce signal est reçu d'une autre interface située en amont sur la première liaison vis-à-vis du traducteur.

3. Circuit de mesure, selon la revendication 2, où une seconde liaison de type série transmet les impulsions de sélection individuelle d'interface émises par la logique commune, où la première et la seconde liaison sont respectivement constituées d'éléments qui sont insérés chacun entre deux interfaces correspondant à deux cellules successives et où au moins deux interfaces correspondant à deux cellules successives sont reliées par deux éléments, l'un de première liaison et l'autre de seconde liaison, comportant chacun une diode de protection (12, 12') montée en série pour agir en cas de tension inverse et notamment en cas de rupture de continuité électrique entre les cellules auxquelles correspondent les interfaces entre lesquelles ces diodes sont montées
